# EUROPEAN PATENT APPLICATION

(11) **EP 1 519 644 A2**
(43) Date of publication of application: **30.03.2005**
(21) Application number: 04104668.1
(22) Date of filing: 24.09.2004
(51) Int. Cl.: H05K 7/14, H01Q 1/10

(54) **Method and apparatus for retarding fire in a telecommunications box**

(30) Priority: 24.09.2003 US 505698 P
(71) Applicant: SIEMENS AKTIENGESELLSCHAFT, 80333 München (DE)
(72) Inventor: Schuster, Siegwald, 82166, Gräfelfing (DE); Polacek -Attenberger, Christian, 81477, München (DE); Cole, Guy A., 33489 Florida (US); Croone, Arthur James, 33435 Florida (US); Edwards, Earl, 33487 Florida (US); Guzik, George Andrew, 33467 Florida (US); Harlan, Don D., 33414 Florida (US); Makooi, Babak B., Boca Raton, Florida 33496 (US)

(57) **Abstract**

Retarding a fire condition of a telecommunications component mounted on a module to be inserted into a telecommunications box is provided. The module may have a planar surface having a first side and a second side generally opposed to the first side. A ventilator provides a cross air flow generally in a direction from the first side to the second side. A first opening in the telecommunications box in an area adjacent of the first side of the planar surface forms a substantial portion of the cross air flow emanating from the first side. A second opening in the telecommunications box arranged in an area adjacent to the second side of the planar surface exhausts the cross flow air, such that the cross flow air substantially retards the fire condition. An air flow guide is provided to simulate an air resistance of a module.

## Description

### BACKGROUND

### Field Of The Invention.

The invention relates to retard a heating or overheating condition and to provide adequate air flow and, more particularly, to meet the inflammability standards in telecommunications devices.

### Related Information.

Telecommunications devices must adhere to certain standards concerning fire security and inflammability. Compliance with these standards is terribly important particularly for public communications. In the case of a fire, telecommunication could be lost over vast geographic areas, which could result in financial loss, public disarray and dissatisfaction with services, and even panic. Therefore, these standards are taken seriously by the industry and all attempts to meet the criteria are taken.

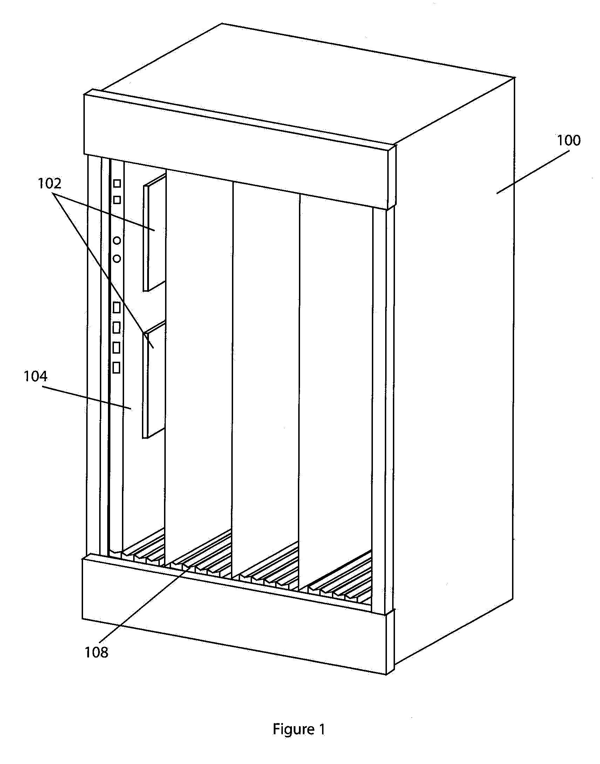

Within a frame 100 of telecommunications devices 102 shown in Fig. 1, herein also referred to as a telecommunications box 100, the fire and flame hazards become a unique challenge to control. The devices 102 must comply with the standards within the closed and tight confines of the frame 100 where modules 104 are fitted into close configurations into frames and these frames are inserted into adjacent shelves of a rack (not illustrated in this figure). Not to mention, that the devices 102 themselves are producing heat and are the probable cause of a combustion. Within such an environment, a great deal of technology has been invested into cooling the telecommunications devices and preventing or extinguishing, or at least retarding, an ensuing fire.

Typically, the racks are tested for compliance with the standards by taking measurements while simultaneously raising the heat load. In regards the American market, these requirements are stringently enforced in accordance with the Telcordia GR63 standard, which prescribes Fire Resistance Criteria for Electronic Components. Currently, GR63 requires that all polymeric materials, components, and interconnect wire and cable used within equipment assemblies comply with one of the following criteria:
- Be formed of materials rated V-0 (UL 94)
- Be formed of materials rated V-1 (UL 94) with an Oxygen Index > 28% (ASTM D2863), or
- Comply with the Needle Flame Test (discrete or in situ)

Practically speaking, inflammable or at least fire resistant materials were used to construct the telecommunications box and components therein.

The conventional wisdom concerning fire within a telecommunications box is to reduce the air flow as much as possible. This arising from the physical principle that air fuels a fire. For this reason, it has been a practice to provide for any openings on the telecommunications box, particularly where the air flow is concerned, such as on the top side, to have means for closing and securing that no air can enter the box. As will be explained, this philosophy is problematic.

Another problem that frustrates the standardized testing is that different telecommunications boxes are differently configured. Under different air flow conditions, the telecommunications box may have different heat dissipation characteristics. For example, when one or more modules are removed from the telecommunications box, the heating dissipation characteristics change. This is shown in Figure 1, by the empty module slots 108.

Moreover, the heating dissipation characteristics change in a way that is unexpected. By removing modules, one would expect that less components would decrease heat, and thus reduce the risk or problems of fire. In principle this is true. However, the heat dissipation problems are exacerbated in the case of a module removed, particularly for those adjacent the module experiencing a fire. The reason for this was determined by experiment, during the development of this invention, to be a lack of air flow due to the missing modules. This is because, without the physical profile of the module, there is inadequate air resistance adjacent the missing module. As a result, an adequate air flow cannot be ensured and, thus, adequate cooling cannot be maintained.

This is certainly problematic, because certain customer configurations do not require functional optical networking circuit packs. Since the empty slots provide no resistance to air flow, most of the air passes through this way as a result. The critical components receive less cooling and can overheat causing reduced system life or in some cases system failure.

The present invention offers a manner in which to retard a heating or overheating condition and to provide adequate air flow. There is provided a manner in which to maintain a working temperature environment in an electronics device and, furthermore, to prevent a fire in a telecommunications device or at least to reduce the flames of a fire substantially so that the fire can be brought under control or stopped from spreading. More specifically, the invention provides a manner in which to fulfill the inflammability standards in telecommunications devices.

### OBJECTS & SUMMARY OF THE INVENTION

An object of the present invention is to provide heating dissipation in a telecommunications device.

An object of the present invention is to retard a heating or overheating condition telecommunications device.

An object of the present invention is to provide adequate air flow telecommunications device.

An object of the present invention is to provide a manner in which to maintain a working temperature environment in an electronics device.

An object of the present invention is to provide to prevent a fire in a telecommunications device.

An object of the present invention is to reduce the flames of a fire substantially so that the fire can be brought under control or stopped from spreading.

An object of the present invention is to provide a manner in which to fulfill the inflammability standards in telecommunications devices.

An object of the present invention is to provide a manner in which to fulfill the GR63 standard.

In accordance with these and other objects of the invention, there is provided an apparatus for retarding a fire condition of a telecommunications component mounted on a module to be inserted into a telecommunications box, the module having a planar surface having a first side and a second side generally opposed to the first side. A ventilator provides a cross air flow generally in a direction from the first side to the second side. A first opening in the telecommunications box in an area adjacent of the first side of the planar surface forms a substantial portion of the cross air flow emanating from the first side. A second opening in the telecommunications box arranged in an area adjacent to the second side of the planar surface exhausts the cross flow air, such that the cross flow air substantially retards the fire condition.

A method is provided for retarding a fire condition of a telecommunications component mounted on a planar surface of a module housed in a telecommunications box, the planar surface having a first side and a second side generally opposed to the first side, wherein a ventilator that provides a cross air flow generally in a direction from the first side to the second side. A step of arranging arranges a first opening in the telecommunications box in an area adjacent of the first side of the planar surface in order to form a substantial portion of the cross air flow emanating from the first side. A step of arranging arranges a second opening in the telecommunications box in an area adjacent to the second side of the planar surface in order to exhaust the cross flow air, such that the cross flow air substantially retards the fire condition.

### BRIEF DESCRIPTION OF THE DRAWINGS

Fig. 1 illustrates a frame of a telecommunications box;
Figs. 2a and 2b illustrate the invention; and
Fig. 3 illustrates the air flow guide of the invention.

### DETAILED DESCRIPTION OF THE PREFERRED EMBODIMENTS

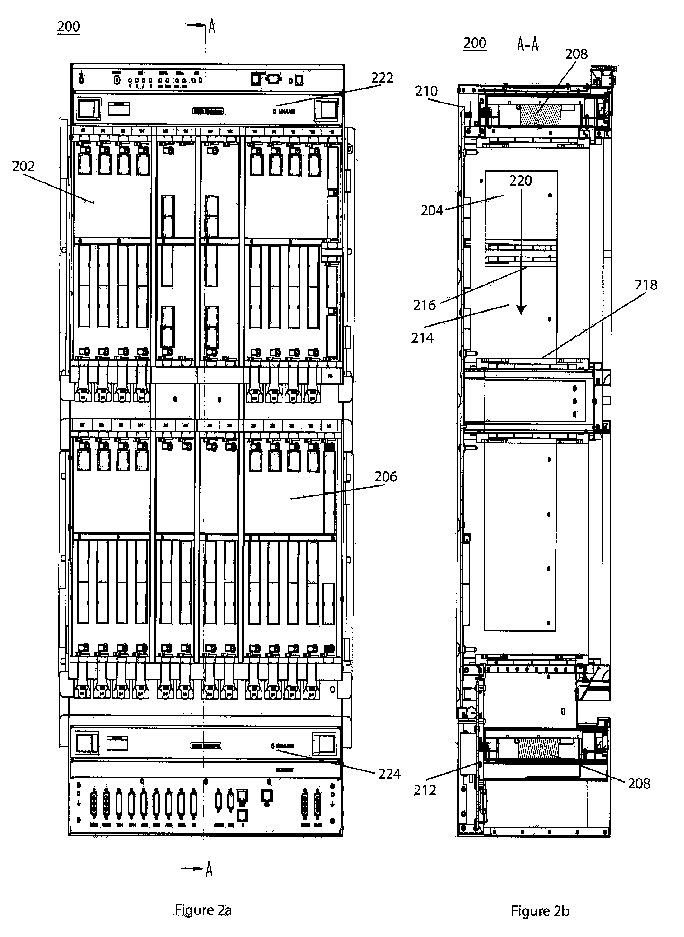

The invention will now be discussed in reference to Figures 2a and 2b wherein front and side-cross section views, respectively, a telecommunications box 200 are generally shown. Modules 202 with telecommunication components 204 mounted thereon are inserted, in this case vertically, into the box 200. The box may contain frames, generally shown by reference numeral 206.

One or more ventilators 208, which may be arranged singularly in several next to each other in a module. In one aspect of the invention, the inventive aspect is to control the ventilator 208 or ventilators in dependence on an air pressure created by the temperature within the box 200.
In one aspect of the invention, the ventilator turns dependent on the measured ambient temperature at a predetermined temperature resistance. This creates the general air flow which tends to cool the electronic components of the telecommunications device. Due to the control of the ventilators in this manner, another advantage is that the operating noise is substantially lowered at e.g. ambient temperature.

One or more ventilators may be arranged in a ventilator drawer 210 situated above in the Figures. A second drawer 212 may be arranged below the elements to be cooled. Of course, the invention is not limited to the arrangement where the ventilator drawers are above and below, but opposite from each other. In another configuration for example the ventilators could be fore and aft, i.e., front and rear, or in another aspect may be diagonally opposed. The result is a cross flow of air that crosses a planar face of a particular module from one side of the module to the opposing side.

In one aspect, the lower module 212 is separated for EMV reasons and because of possibly burning construction units that fall through a perforated sheet metal lying over it. This placement offers an ideal ventilator redundancy in case of failure of a ventilator or with exchange of ventilator drawer. In case of one or more ventilator failure, the invention provides that the still intact or remaining ventilator is switched to full number of revolutions.

The advantage concerning the behavior in case of fire, however, is due to the fact that one or more separate thermal relays, arranged in the environment of the upper ventilator module, the lower ventilator on full can regulate temperatures over approximately 90 C.

The upper ventilators run in the case of fire because of the temperature resistance applied there on full number of revolutions, however in the case of flames directly blazing under it could be already destroyed. The high turning ventilators cause the air flow to rise and the above operating, heated elements there tend to be cooled down.

A test of the invention was conducted in accordance with the GR63 testing parameters, which calls for a pipe with horizontal gas flames to be inserted into the equipment. The influx gas flow is then increased linear up to a maximum value and then decreased to zero. Thereby, only within certain limits flames and developed smoke may the goal of testing be ascertained.

Under these conditions, the flames and smoke existing as energy within the Box is to transferred upward in the best possible manner by the ventilator away from the equipment.
Thus, the ignition temperature of the inflammatory construction units even when brought up to the high point of the gas supplied (= largest flame development) after approximately 1 minute is not reached.

In addition, the lower ventilators where run during the test. On maximum permissible engine speed, the ventilators operated correctly since they the are below or outside fire area.

In addition to control of the ventilator, the invention prevents or retards a fire condition of a telecommunications component mounted on a module to be inserted into a telecommunications box by providing for a cross flow of air. As previously mentioned, the preeminent thinking is additional air increases the incendiary effect. However, while this in principle true, it has been found in the invention that the opposite is true, at least for electronic components stored in racks or frames.

For description, let us define the module as having a planar surface 214 having a first side 216 and a second side 218 generally opposed to the first side. Of course, planar does not necessarily mean but that it has a general plane surface. In the invention, the ventilator 208 provides a cross air flow 220 generally in a direction from the first side to the second side.

A first opening 222 in the telecommunications box 200 in an area adjacent the first side of the planar surface. The first opening provides the inlet for a substantial portion of the cross air flow emanating from the first side.

A second opening 224 in the telecommunications box 200 arranged in an area adjacent to the second side of the planar surface in order to exhaust the cross flow air. In the invention, it was found through experimentation that, through the operation of the assisted air provided by the openings, the cross flow air substantially retards the fire condition. Indeed, it was observed that flames inside the telecommunications box were substantially reduced owing to the present invention.

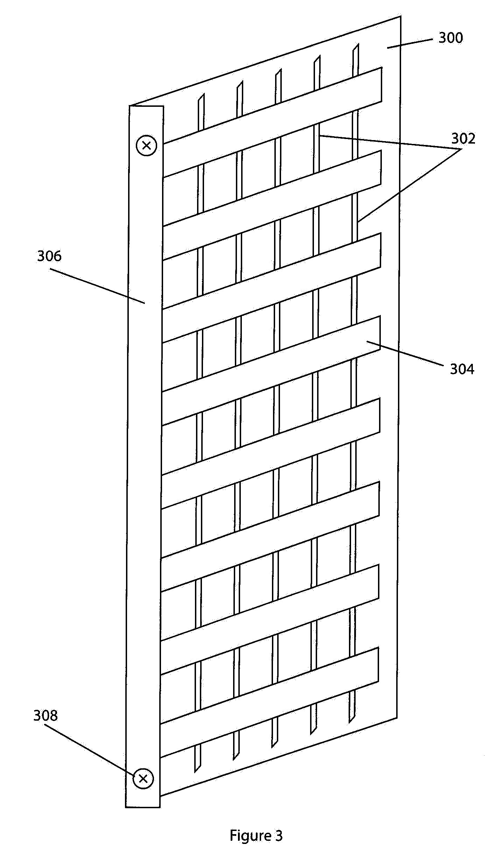

In another aspect of the invention shown in Figure 3, there is provided an air flow guide 300 for simulating an air resistance of a module. As discussed with reference to Figure 1, a lack of air flow due to the missing modules changes the heating dissipation. This is because, without the physical profile of the module, there is inadequate air resistance adjacent the missing module. As a result, an adequate air flow cannot be ensured and, thus, adequate cooling cannot be maintained.

The present invention simulates the component friction and causes air flow resistance, thereby balancing the cooling air flow towards the functional cards. Through testing, it has been proven that the air flow guide of the present invention reduces critical temperatures by over 7 deg C.

Now with reference to Figure 3, the invention provides the air flow guide 300 with fins that are arranged in strategic locations to increase air pressure. The fins (or fin) 302 simulate the pressure created by electronic components on the module. Although the configuration shown in Figure 3 was tested and proven to satisfy the flammability standard, the air flow guide 300 may be of a number of different configurations. For example, the fins need not be uniformly distributed although so depicted. Also, the fins need not be so shaped in rectangular cut outs. Nor does there have to be a plurality of fins, but there may be a single fin.

Openings 304 shown in Figure 3 are conveniently produced by stamping out the fins during manufacture. The openings may provide a lateral or through current of air through the module. In any event, it is not necessary to have the openings for the invention to work.

The general shape and form of the air flow guide is preferable in the form of a module. That is, it may be generally rectangular with a planar profile. There may also be a front panel 306 and thumb screws 308 for fitting the air flow guide into an existing slot of a telecommunications box.

It shall also be appreciated that the invention need not necessarily require all empty slots to be filled with an air flow guide. It is possible to insert air flow guides in the adjacent empty slots, adjacent that is to a module. However, the testing was performed with all empty slots filled with an air flow guide and the optimum results were achieved.

The invention has been described with respect to particular examples shown in the figures. However, it shall be understood that the invention encompasses more than the particular embodiments shown and that the invention shall not be limited thereby.

## Claims

1. An apparatus for retarding a fire condition of a telecommunications component mounted on a module to be inserted into a telecommunications box, the module having a planar surface having a first side and a second side generally opposed to the first side, the apparatus comprising:
a ventilator that provides a cross air flow generally in a direction from the first side to the second side;
a first opening in the telecommunications box in an area adjacent of the first side of the planar surface in order to form a substantial portion of the cross air flow emanating from the first side; and
a second opening in the telecommunications box arranged in an area adjacent to the second side of the planar surface in order to exhaust the cross flow air, such that the cross flow air substantially retards the fire condition.

2. The apparatus of claim 1, wherein the cross flow air retards the fire condition sufficiently to comply with GS63.

3. The apparatus of claim 1, wherein the first opening is arranged along a top side of the telecommunications box.

4. The apparatus of claim 1, wherein the second opening is arranged along a bottom side of the telecommunications box.

5. The apparatus of claim 1, further comprising an air flow guide being configured in a shape that simulates an air flow resistance of another module adjacent to the module.

6. The apparatus of claim 5, wherein the air flow guide has mounted thereon at least one fin for generating the simulated air flow resistance.

7. The apparatus of claim 6, wherein a planar face of the fin is arranged substantially perpendicular to the direction of the cross air flow.

8. The apparatus of claim 6, further comprising a plurality of fins arranged uniformly across the air flow guide.

9. The apparatus of claim 5, further comprising openings in the air flow guide to assist through ventilation.

10. The apparatus of claim 1, further comprising a controller for controlling the ventilator in dependence on an ambient temperature pressure.

11. A method for retarding a fire condition of a telecommunications component mounted on a planar surface of a module housed in a telecommunications box, the planar surface having a first side and a second side generally opposed to the first side, wherein a ventilator that provides a cross air flow generally in a direction from the first side to the second side, the method comprising the steps of:
arranging a first opening in the telecommunications box in an area adjacent of the first side of the planar surface in order to form a substantial portion of the cross air flow emanating from the first side; and
arranging a second opening in the telecommunications box in an area adjacent to the second side of the planar surface in order to exhaust the cross flow air, such that the cross flow air substantially retards the fire condition.

12. The method of claim 11, wherein the cross flow air retards the fire condition sufficiently to comply with GS63.

13. The method of claim 11, further comprising the step of determining a size of the first opening such that the effect of retarding the fire condition by the cross flow air is optimized.

14. The method of claim 11, further comprising the step of providing an air flow guide that simulates an air flow resistance of another module.

15. The method of claim 14, further comprising the step of arranging the air flow guide adjacent to the module.

16. The method of claim 11, further comprising the step of providing at least one fin on the air flow guide arranged generally perpendicular to the module.

17. The method of claim 11, further comprising the step of controlling the ventilator in dependence on an ambient temperature pressure.
